# EUROPÄISCHE PATENTSCHRIFT

(11) **EP 3 072 153 B1**
(45) Veröffentlichungstag und Bekanntmachung des Hinweises auf die Patenterteilung: **10.01.2018**
(21) Anmeldenummer: 14796113.0
(22) Anmeldetag: 11.11.2014
(51) Int. Cl.: H01L 23/34, H01L 23/373

(54) **VORRICHTUNG MIT EINEM LEISTUNGSELEKTRONIKMODUL ZUM VERSORGEN EINES ELEKTRISCHEN VERBRAUCHERS EINES HAUSHALTSGERÄTS MIT ELEKTRISCHER VERSORGUNGSSPANNUNG, HAUSHALTSGERÄT UND VERFAHREN ZUM HERSTELLEN EINER DERARTIGEN VORRICHTUNG**
DEVICE HAVING A POWER ELECTRONICS MODULE FOR SUPPLYING AN ELECTRIC LOAD OF A HOUSEHOLD APPLIANCE WITH ELECTRICAL SUPPLY VOLTAGE, HOUSEHOLD APPLIANCE, AND METHOD FOR PRODUCING SUCH A DEVICE
DISPOSITIF ÉQUIPÉ D'UN MODULE ÉLECTRONIQUE DE PUISSANCE POUR FOURNIR UNE TENSION D'ALIMENTATION ÉLECTRIQUE À UN CONSOMMATEUR ÉLECTRIQUE D'UN APPAREIL ÉLECTROMÉNAGER, APPAREIL ÉLECTROMÉNAGER ET PROCÉDÉ DE FABRICATION D'UN TEL DISPOSITIF

(30) Priorität: 18.11.2013 DE 102013223430
(43) Veröffentlichungstag der Anmeldung: 28.09.2016
(73) Patentinhaber: BSH Hausgeräte GmbH, 81739 München (DE)
(72) Erfinder: SKRIPPEK, Jörg, 14641 Wustermark (DE); ALBAYRAK, Hasan Gökcer, 13469 Berlin (DE); SEIDL, Rudolf, 93057 Regensburg (DE)
(86) Internationale Anmeldenummer: PCT/EP2014/074226
(87) Internationale Veröffentlichungsnummer: WO 2015/071238

(56) Entgegenhaltungen:
- EP-A1- 1 455 391
- DE-A1-102004 019 431
- DE-A1-102006 056 363
- DE-A1-102011 080 153
- DE-A1-102011 088 969
- DE-B3-102004 040 773
- JP-A- H04 273 150
- JP-A- H07 263 621
- US-A- 5 747 875
- US-A- 5 942 797
- US-A1- 2009 024 345
- US-A1- 2009 129 432

## Beschreibung

Die Erfindung betrifft eine Vorrichtung zum Versorgen eines elektrischen Verbrauchers eines Haushaltsgeräts mit elektrischer Versorgungsspannung, insbesondere mit einer Wechselspannung, umfassend ein Leistungselektronikmodul, welches eine Hybridleiterplatte mit einem ersten Schaltungsträger und einem zweiten Schaltungsträger aufweist, wobei ein Übergangsbereich zwischen dem ersten und dem zweiten Schaltungsträger eine gegenüber dem ersten und/oder dem zweiten Schaltungsträger geringere Wärmeleitfähigkeit aufweist, sowie umfassend eine Temperaturschutzeinrichtung zum Temperaturschutz des Leistungselektronikmoduls. Auf dem ersten Schaltungsträger der Hybridleiterplatte ist zumindest ein Halbleiterschalter angeordnet, der zum Erzeugen der Versorgungsspannung für den elektrischen Verbraucher ausgebildet ist. Auf dem zweiten Schaltungsträger wiederum ist ein Temperatursensor der Temperaturschutzeinrichtung angeordnet, der zum Erfassen einer Temperatur ausgebildet ist, welcher der zumindest eine Halbleiterschalter im Betrieb der Vorrichtung ausgesetzt ist. Die Erfindung betrifft außerdem ein Haushaltsgerät mit einem elektrischen Verbraucher, insbesondere einer elektrischen Maschine, und mit einer erfindungsgemäßen Vorrichtung. Die Erfindung betrifft auch ein Verfahren zum Herstellen einer solchen Vorrichtung.

Leistungselektronikmodule (auch kurz "Leistungsmodule" genannt) werden in Haushaltsgeräten zur Versorgung von elektrischen Maschinen mit elektrischer Wechselspannung eingesetzt. Solche Leistungsmodule beinhalten üblicherweise mehrere Halbleiterschalter, beispielsweise so genannte IGBTs, welche einen Bestandteil eines so genannten Inverters darstellen und aus einer Zwischenkreisgleichspannung eine elektrische Versorgungsspannung erzeugen, mit welcher eine elektrische Maschine bzw. ein Antriebsmotor versorgt wird. Abhängig von der Ausgestaltung der elektrischen Maschine werden dabei eine oder mehrere Phasen erzeugt, beispielsweise drei Phasen bei einer dreiphasigen Synchronmaschine. Die Anzahl der eingesetzten Halbleiterschalter ist dann auch abhängig der Anzahl der benötigten Phasen. Die Transistoren sind hier in einer Brückenschaltung verschaltet.

Ein Leistungsmodul ist beispielsweise aus dem Dokument DE 10 2007 005 233 A1 bekannt. Die Leistungshalbleiter befinden sich hier sandwichartig zwischen elektrisch isolierenden und hochwärmeleitfähigen Schichten, welche beispielsweise die keramischen Kerne von DCB/DAB oder AMB-Substraten sind. Diese Sandwichanordnung ist von einer dünnwandigen Hülle aus einem metallischen Werkstoff umgeben und über diese an einen Kühlkörper thermisch angebunden. Zur Oberflächenvergrößerung können auf diese Modulhülle unterschiedliche Formteile aufgebracht werden, zum Beispiel aus geprägter Metallfolie oder dergleichen.

Eine Kühlvorrichtung für ein Leistungselektronikmodul ist beispielsweise aus der Druckschrift DE 10 2011 007 171 A1 bekannt. Die Kühlvorrichtung umfasst einen Grundkörper, auf welchem zumindest bereichsweise ein Wärme ableitendes Graphitmaterial ausgebildet ist.

In der US 2011/0133320 A1 ist ein Hybrid-Leistungselektronikmodul offenbart, bei dem Halbleiterschalter auf einem Die-Pad untergebracht sind und ein Temperatursensor auf einem zweiten Die Pad untergebracht ist. Beide Die-Pads sind auf einem gemeinsamen metallenen Schaltungsträger angeordnet und miteinander zu einem Hybrid-Modul vergossen. Durch die Anordnung auf einem gemeinsamen Schaltungsträger ist ein guter Wärmeübergang von dem Halbleiterschalter zum Temperatursensor gewährleistet.

Die JP H04 273150 A befaßt sich mit dem Problem, die entstehende Verlustwärme aus dem Leistungsteil der Schaltung effektiv abzuleiten. Ein Leistungsteil ist dazu auf einem anderen Substrat angebracht, als der Steuerteil. Ein Substrat ist für eine hohe Wärmeleitfähigkeit ausgelegt, während das andere Substrat für eine verbesserte Schaltung ausgelegt ist. Beide Schaltungsteile sind mittels Bonding-Drähten verbunden.

Die US 2009 0129432 A1 beschäftigt sich mit dem Problem, eine Temperaturschutzschaltung für eine Leistungsschaltung thermisch an das Substrat der Leistungsschaltung anzukoppeln. Hierbei wird eine Anschlußklemme, die von dem Leistungssubstrat auf eine darüber huckepack aufgeständerte Leiterplatte führt, als Wärmeleiter benutzt.

In der DE 10 2011 088 969 A1 ist ein Modul mit einer Ansteuerschaltung für ein elektrisches Leistungsbestandteil eines Getriebes offenbart. Die Druckschrift beschäftigt sich mit dem Schutz der Schaltung vor dem Getriebefluid. In der Schaltung entstehende Wärme soll über das Substrat an großflächige Kupferleiterbahnen auf einer Leiterplatte abgeführt werden.

Die US 5 747 875 beschäftigt sich mit der Abfuhr von Verlustwärme aus einer Schaltungseinheit mit einem Leistungsschaltungsteil und einem. Die Verlustwärme wird dabei aus dem Hauptschaltkreis), der auf einem Leistungssubstrat aufgebracht ist, zu einem Kühlkörper abgeführt. Dazu ist eine Wärmeleitplatte vorgesehen, die sich an der Gehäuseunterseite befindet und in direktem Kontakt mit dem Leitungssubstrat steht.

Die Erfindung geht von einem Leistungselektronikmodul aus, bei welchem eine Hybridleiterplatte eingesetzt wird, welche zwei oder mehrere verschiedene Schaltungsträger aufweist, nämlich einen ersten Schaltungsträger mit zumindest einer Schicht aus einem hochwärmeleitfähigen Material - beispielsweise mit zumindest einer Keramik-Schicht und optional auch mit zumindest einer Metallschicht - sowie einen zweiten Schaltungsträger mit einer deutlich geringeren Wärmeleitfähigkeit - insbesondere aus organischem Kunststoff, wie beispielsweise aus glasfaserverstärktem Epoxidharz (FR4). Solche Hybridleiterplatten können insgesamt kostengünstiger hergestellt werden, da sie nicht vollständig aus Keramik hergestellt werden müssen. Die Leistungshalbleiter sind dabei üblicherweise auf dem keramischen Schaltungsträger angeordnet, während andere Bauelemente, die inbesondere der Ansteuerung der Halbleiterschalter dienen, auf dem herkömmlichen FR4-Schaltungsträger angebracht sind. Bei diesen Bauelementen handelt es sich beispielsweise um so genannte Treiber zur Ansteuerung der Halbleiterschalter. Auf dem herkömmlichen FR4-Schaltungsträger ist in der Regel außerdem ein Temperatursensor angeordnet, der zur Erfassung der Temperatur der Halbleiterschalter dient. Dieser Temperatursensor ist Bestandteil einer Temperaturschutzeinrichtung, welche die Temperatur der Halbleiterschalter im Betrieb überwacht und gegebenenfalls den Laststromkreis unterbricht.

Um eine gute Wärmeübertragung zwischen den Halbleiterschaltern einerseits und dem Temperatursensor andererseits und somit eine zuverlässige Erfassung der Temperatur im Betrieb zu ermöglichen, wird das Leistungselektronikmodul üblicherweise mit einer relativ großen Anpresskraft an einen Kühlkörper thermisch angebunden. Da die Hybridleiterplatte nur eine unzureichende Wärmeleitfähigkeit aufweist, wird die Wärme hier über den Kühlkörper übertragen. Wird der Kühlkörper jedoch nicht korrekt montiert oder verringert sich die Anpresskraft zwischen dem Leistungsmodul und dem Kühlkörper, so wird die Temperatur der Halbleiterschalter von dem Temperatursensor nicht richtig erfasst, und ein Übertemperaturschutz kann nicht mehr sichergestellt werden. Im ungünstigsten Fall kann es hier zu einer Zerstörung des gesamten Elektronikmoduls kommen.

Es ist Aufgabe der Erfindung, eine Lösung aufzuzeigen, wie bei einer Vorrichtung der eingangs genannten Gattung das Leistungselektronikmodul vor Übertemperatur besonders zuverlässig geschützt werden kann.

Diese Aufgabe wird erfindungsgemäß durch eine Vorrichtung, durch ein Haushaltsgerät sowie durch ein Verfahren mit den Merkmalen gemäß den jeweiligen unabhängigen Patentansprüchen gelöst. Vorteilhafte Ausführungen der Erfindung sind Gegenstand der abhängigen Patentansprüche, der Beschreibung und der Figuren.

Eine erfindungsgemäße Vorrichtung ist zum Versorgen eines elektrischen Verbrauchers, insbesondere einer elektrischen Maschine, eines Haushaltsgeräts mit elektrischer Versorgungsspannung ausgebildet, insbesondere mit einer Wechselspannung. Die Vorrichtung umfasst ein Leistungselektronikmodul sowie eine Temperaturschutzeinrichtung. Das Leistungselektronikmodul hat eine Hybridleiterplatte mit einem ersten Schaltungsträger und einem zweiten Schaltungsträger. Ein Übergangsbereich zwischen dem ersten und dem zweiten Schaltungsträger weist gegenüber dem ersten und/oder dem zweiten Schaltungsträger eine geringere Wärmeleitfähigkeit auf. Der zweite Schaltungsträger weist dabei vorzugsweise eine gegenüber dem ersten Schaltungsträger geringere Wärmeleitfähigkeit auf. Die Temperaturschutzeinrichtung ist zum Temperaturschutz des Leistungselektronikmoduls ausgebildet. Auf dem ersten Schaltungsträger der Hybridleiterplatte ist zumindest ein Halbleiterschalter angeordnet, der zum Erzeugen der Versorgungsspannung für den elektrischen Verbraucher ausgebildet ist. Der zumindest eine Halbleiterschalter kann beispielsweise ein IGBT sein. Auf dem zweiten Schaltungsträger wiederum ist ein Temperatursensor angeordnet, welcher zum Erfassen einer Temperatur ausgebildet ist, welcher der zumindest eine Halbleiterschalter im Betrieb der Vorrichtung ausgesetzt ist. Der Temperatursensor erfasst also die Temperatur des zumindest einen Halbleiterschalters. Erfindungsgemäß ist an dem Leistungselektronikmodul, insbesondere an einem Modulgehäuse, eine thermisch leitfähige Folie angeordnet, über welche der zumindest eine Halbleiterschalter und der Temperatursensor miteinander thermisch gekoppelt sind.

Um die Wärmeleitung zwischen dem zumindest einen Halbleiterschalter einerseits und dem Temperatursensor andererseits im Betrieb der Vorrichtung sicherzustellen, wird auf dem Leistungselektronikmodul also eine Wärmeleitfolie angebracht. Versuche haben gezeigt, dass eine derartige thermisch leitfähige Folie für eine ausreichende Wärmeleitung bzw. Wärmeübertragung zwischen dem Halbleiterschalter und dem Temperatursensor sorgt. Dies gilt insbesondere auch dann, wenn diese Folie zwischen einem Kühlkörper und dem Leistungselektronikmodul angeordnet ist und der Kühlkörper fehlerhaft montiert wurde oder im Betrieb der Vorrichtung aufgrund von Materialermüdung einer Verschraubung oder einer Klammerverbindung abfällt. Die Wärmeübertragung durch die Folie ist somit auch ohne den Kühlkörper grundsätzlich gewährleistet. Durch diese Wärmeübertragung kann die Temperatur des Halbleiterschalters im Betrieb der Vorrichtung korrekt erfasst und durch eine Steuereinheit entsprechend ausgewertet werden. Wird beispielsweise festgestellt, dass die Temperatur einen vorgegebenen Grenzwert überschreitet, so kann der Laststromkreis unterbrochen und das gesamte Leistungselektronikmodul somit zuverlässig geschützt werden.

Vorzugsweise erstreckt sich die thermisch leitfähige Folie zumindest im Wesentlichen vollflächig über zumindest eine Seite des Leistungselektronikmoduls und überlappt somit sowohl den Temperatursensor als auch den zumindest einen Halbleiterschalter. Insbesondere kann die Folie dabei an einem Modulgehäuse des Leistungselektronikmoduls angebracht sein. Die Folie liegt bevorzugt an einem metallischen Gehäusebereich des Modulgehäuses, welcher den ersten Schaltungsträger kontaktiert, sowie an einem weiteren Gehäusebereich an, welcher aus Kunststoff ist und den zweiten Schaltungsträger kontaktiert.

Ist kein geschlossenes Modulgehäuse vorhanden, so kann alternativ auch vorgesehen sein, dass die Folie auf dem Temperatursensor aufliegt und sich von dem Temperatursensor zumindest hin zu dem Halbleiterschalter erstreckt und auch auf dem Halbleiterschalter aufliegt. Die Wärmeübertragung findet dann bevorzugt unmittelbar über die thermisch leitfähige Folie statt.

In einer Ausführungsform ist vorgesehen, dass der erste Schaltungsträger zumindest eine Keramik-Schicht aufweist. Optional kann der erste Schaltungsträger auch zumindest eine Metallschicht aufweisen. Insbesondere in Verbindung mit den Leistungshalbleitern erweist sich ein aus Keramik gebildeter Schaltungsträger als besonders vorteilhaft, da Keramik eine relativ gute Wärmeleitfähigkeit aufweist und somit für eine gute Wärmeverteilung auf dem ersten Schaltungsträger und eine gute Wärmekopplung zur Folie sorgt.

Der Einsatz der thermisch leitfähigen Folie erweist sich wiederum dann als besonders vorteilhaft, wenn der zweite Schaltungsträger organischen Kunststoff aufweist, bevorzugt aus organischem Kunststoff gebildet ist, insbesondere aus einem Epoxidharz umfassenden Material, wie beispielsweise aus glasfaserverstärktem Epoxidharz bzw. FR4. Organische Kunststoffe weisen nämlich eine relativ geringe Wärmeleitfähigkeit auf, sodass hier die Folie für einen zuverlässigen Betrieb der Temperaturschutzeinrichtung sorgt.

In einer Ausführungsform ist vorgesehen, dass die Vorrichtung zusätzlich einen Kühlkörper zur Wärmeabfuhr von dem Leistungselektronikmodul aufweist. Bei dieser Ausführungsform ist das Leistungselektronikmodul über die Folie an den Kühlkörper thermisch angebunden. Dies bedeutet, dass die Folie in Sandwich-Bauweise zwischen dem Leistungselektronikmodul einerseits und dem Kühlkörper andererseits angeordnet ist. Dies hat den Vorteil, dass die Folie hier eine weitere Funktion übernimmt, nämlich die Wärmeleitung von dem Leistungselektronikmodul zum Kühlkörper. Somit ist auch die Wärmeübertragung zwischen dem Leistungselektronikmodul und dem Kühlkörper zuverlässig sichergestellt.

Hinsichtlich der Wärmeübertragung hat es sich als vorteilhaft erwiesen, wenn die Folie aus einem Material ist, welches Graphit und/oder Kupfer umfasst. Beispielsweise kann eine Graphitfolie oder aber eine Kupferfolie eingesetzt werden. Es hat sich herausgestellt, dass eine 0,25mm dicke Graphitfolie bereits ausreichend ist, um eine gute Wärmeleitung zwischen dem Halbleiterschalter einerseits und dem Temperatursensor sicherzustellen. Versuche haben gezeigt, dass dies auch dann gewährleistet ist, wenn der Kühlkörper fehlerhaft montiert wurde und somit die benötigte Anpresskraft nicht gegeben war. Eine ausreichende Wärmeübertragung ist auch dann gegeben, wenn der Kühlkörper im Betrieb abfällt, etwa aufgrund von Ermüdung der Verschraubung oder Klammerverbindung.

Vorzugsweise ist die Folie auf das Leistungselektronikmodul aufgeklebt. Beispielsweise kann dabei eine einseitig oder zweiseitig selbstklebende Wärmeleitfolie verwendet werden, welche bei der Fertigung des Leistungselektronikmoduls ohne viel Aufwand auf dieses aufgeklebt werden kann, ohne dass zusätzliche Klebstoffe genutzt werden müssen. Eine Klebeverbindung sorgt außerdem für eine rutschfeste und somit betriebssichere Anbringung und präzise Positionierung der Folie am Leistungselektronikmodul.

Die Erfindung betrifft außerdem ein Haushaltsgerät mit einem elektrischen Verbraucher, insbesondere einer elektrischen Maschine, und mit einer erfindungsgemäßen Vorrichtung, welche den elektrischen Verbraucher mit elektrischer Versorgungsspannung versorgt.

Ein erfindungsgemäßes Verfahren dient zum Herstellen einer Vorrichtung zum Versorgen eines elektrischen Verbrauchers eines Haushaltsgeräts mit elektrischer Versorgungsspannung. Es wird ein Leistungselektronikmodul bereitgestellt, welches eine Hybridleiterplatte mit einem ersten Schaltungsträger und einem zweiten Schaltungsträger aufweist, der insbesondere gegenüber dem ersten Schaltungsträger eine geringere Wärmeleitfähigkeit aufweist. Zwischen dem ersten und dem zweiten Schaltungsträger besteht eine schlechte Wärmeübertragung. Es wird auch eine Temperaturschutzeinrichtung zum Temperaturschutz des Leistungselektronikmoduls bereitgestellt, wobei auf dem ersten Schaltungsträger zumindest ein Halbleiterschalter angeordnet wird, der zum Erzeugen der Versorgungsspannung ausgebildet ist, und auf dem zweiten Schaltungsträger der Hybridleiterplatte ein Temperatursensor der Temperaturschutzeinrichtung zum Erfassen einer Temperatur des Halbleiterschalters angeordnet wird. An dem Leistungselektronikmodul wird eine thermisch leitfähige Folie angeordnet, über welche der zumindest eine Halbleiterschalter und der Temperatursensor thermisch miteinander verbunden werden.

Die mit Bezug auf die erfindungsgemäße Vorrichtung vorgestellten bevorzugten Ausführungsformen und deren Vorteile gelten entsprechend für das erfindungsgemäße Haushaltsgerät sowie für das erfindungsgemäße Verfahren.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder aber in Alleinstellung verwendbar.

Die Erfindung wird nun anhand eines bevorzugten Ausführungsbeispiels sowie unter Bezugnahme auf die beigefügten Zeichnungen näher erläutert.

Es zeigen:
- Fig. 1: in schematischer Darstellung eine Schnittansicht durch eine Vorrichtung gemäß einer Ausführungsform der Erfindung;
- Fig. 2: in schematischer und perspektivischer Darstellung ein Leistungselektronikmodul der Vorrichtung;
- Fig. 3: in schematischer Darstellung eine Draufsicht auf das Leistungselektronikmodul;
- Fig. 4: in schematischer Darstellung eine Draufsicht auf das Leistungselektronikmodul mit einer Folie; und
- Fig. 5: in schematischer Darstellung eine Seitenansicht auf die Vorrichtung, wobei das Leistungselektronikmodul und ein Kühlkörper auf einer Platine angeordnet sind.

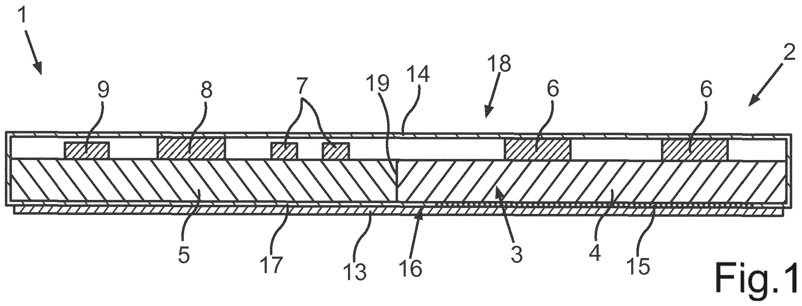

Eine in Fig. 1 in abstrakter Darstellung gezeigte und insgesamt mit 1 bezeichnete Vorrichtung ist zum Einsatz in einem Haushaltsgerät konzipiert und dient zum Versorgen eines elektrischen Verbrauchers, insbesondere einer elektrischen Maschine, mit elektrischer Versorgungsspannung. Die Vorrichtung 1 umfasst ein Leistungselektronikmodul 2, welches eine Hybridleiterplatte 3 aus einem ersten Schaltungsträger 4 und einem zweiten Schaltungsträger 5 umfasst. Der erste Schaltungsträger 4 hat im Vergleich zum zweiten Schaltungsträger 5 eine größere Wärmeleitfähigkeit. Im Ausführungsbeispiel ist der erste Schaltungsträger 4 aus Keramik und kann optional auch mehrere Keramikschichten aufweisen. Der erste Schaltungsträger 4 kann optional auch zumindest eine Metallschicht aufweisen. Der zweite Schaltungsträger 5 ist im Ausführungsbeispiel eine herkömmliche FR4-Platine. Die Schaltungsträger 4, 5 sind in einem Übergangsbereich 19 miteinander verbunden. Aufgrund der Ausgestaltung der Hybridleiterplatte 3 aus zwei separaten Schaltungsträgern 4, 5 ist die Wärmeübertragung in dem Übergangsbereich 19 nur unzureichend. Außerdem weist auch das Material des zweiten Schaltungsträgers 5 eine ungenügende Wärmeleitfähigkeit auf.

Auf dem ersten Schaltungsträger 4 - optional auch in Multilayer-Technologie - sind Leistungshalbleiter angeordnet, nämlich mehrere Halbleiterschalter 6 und nicht dargestellte Dioden. Die Halbleiterschalter 6 können IGBTs sein. Die Halbleiterschalter 6 sind Bestandteil eines Inverters, welcher zum Erzeugen einer Wechselspannung als Versorgungsspannung aus einer Zwischenkreisgleichspannung dient. Gegebenenfalls können auch mehrere Wechselspannungen erzeugt werden, wenn die elektrische Maschine eine mehrphasige Maschine ist.

Zur Ansteuerung der Halbleiterschalter 6 wird eine Treiberschaltung 7 verwendet, welche auf dem zweiten Schaltungsträger 5 angeordnet ist. Auf dem zweiten Schaltungsträger 5 ist außerdem ein Temperatursensor 8, beispielsweise ein NTC-Sensor (Negative Temperature Coefficient) einer nicht näher bezeichneten Temperaturschutzeinrichtung angeordnet. Optional können auf dem zweiten Schaltungsträger 5 auch weitere elektronische Bauelemente 9 angeordnet sein.

Der Temperatursensor 8 dient zum Erfassen der Temperatur der Halbleiterschalter 6 im Betrieb der Vorrichtung. Die Messwerte der Temperatur werden an eine Steuereinheit übermittelt, welche die Messwerte mit einem abgelegten Schwellwert vergleicht. Wird der Schwellwert überschritten, so kann die Steuereinheit den Laststromkreis der Halbleiterschalter 6 unterbrechen und die Vorrichtung 1 bzw. das Leistungselektronikmodul 2 vor Übertemperatur schützen.

Das Leistungselektronikmodul 2 weist ein Modulgehäuse 14 auf, in welchem die Hybridleiterplatte 3 untergebracht ist. Das Modulgehäuse 14 umhüllt bzw. ummantelt also die Hybridleiterplatte 3 mit den elektronischen Bauelementen 6, 7, 8, 9. Das Modulgehäuse 14 ist dabei überwiegend aus Kunststoff gebildet. Lediglich ein rechteckiger Gehäusebereich 15 ist aus Metall, insbesondere aus Kupfer, gebildet. Dieser metallische Gehäusebereich 15 liegt unmittelbar an dem ersten Schaltungsträger 4 an und ist in gegenseitiger Überlappung mit den Halbleiterschaltern 6 angeordnet.

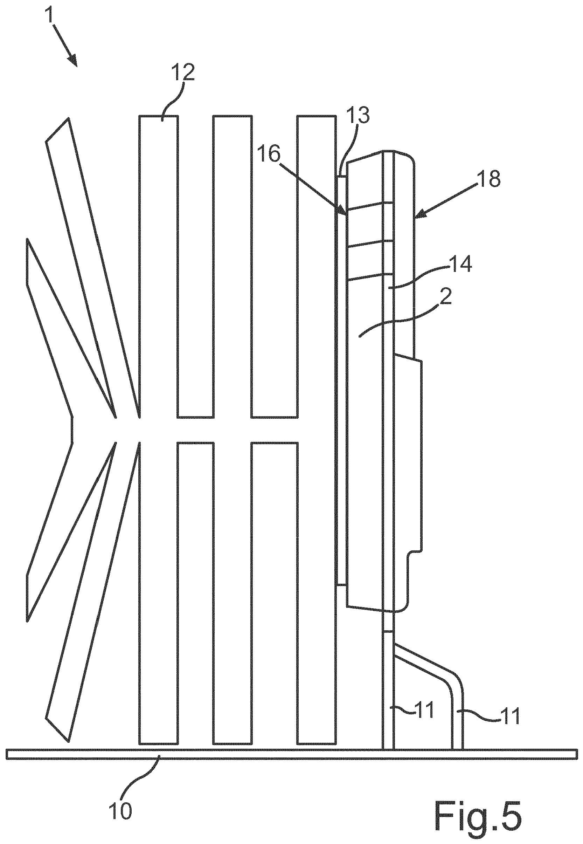

Ein solches Leistungselektronikmodul 2, wie es in Fig. 1 schematisch dargestellt ist, wird auf einer separaten Platine 10 befestigt, wie in Fig. 5 gezeigt. Die Platine 10 ist dabei eine herkömmliche FR4-Leiterplatte. Das Leistungselektronikmodul 2 ist über elektrische Kontaktelemente 11 elektrisch an die Platine 10 angeschlossen. Die Verbindung ist hier in THT-Technologie (Through Hole Technology) realisiert. Die genannte Steuereinheit und ein elektrischer Zwischenkreis mit einem Zwischenkreiskondensator (nicht dargestellt) sind ebenfalls separat zum Leistungselektronikmodul 2 auf der Platine 10 angeordnet. Wie aus Fig. 5 hervorgeht, wird auf der Platine 10 zusätzlich auch ein Kühlkörper 12 zur Wärmeabfuhr von dem Leistungselektronikmodul 2 befestigt. Aufgrund der ungenügenden Wärmeübertragung des Übergangsbereichs 19 zwischen den Schaltungsträgern 4, 5 erfolgt im Stand der Technik die Wärmeübertragung von den Halbleiterschaltern 6 zum Temperatursensor 8 über den Kühlkörper 12. Dazu wird das Leistungselektronikmodul 2 mit einer relativ großen Anpresskraft an den Kühlkörper 12 angebunden. Die benötigte Anpresskraft wird üblicherweise mittels Verschraubung oder Klammerverbindung realisiert. Wird der Kühlkörper 12 jedoch fehlerhaft montiert oder fällt dieser im Betrieb der Vorrichtung 1 aufgrund von Materialermüdung der Verschraubung oder Klammerverbindung ab, so ist eine zuverlässige Wärmeübertragung zwischen den Halbleiterschaltern 6 und dem Temperatursensor 8 nicht mehr gewährleistet. Um diese Wärmeübertragung auch unabhängig von dem Kühlkörper 12 zu ermöglichen, wird auf das Leistungselektronikmodul 2 eine thermisch leitfähige Folie 13 geklebt, beispielsweise eine selbstklebende Folie. Diese kann einseitig oder doppelseitig klebbar sein.

Mit erneutem Bezug auf Fig. 1 wird die Folie 13 vollflächig auf eine erste Seite 16 des Leistungselektronikmoduls 2 aufgeklebt, an welcher sich auch der metallische Gehäusebereich 15 befindet. Die Folie 13 verbindet somit den Gehäusebereich 15 thermisch mit einem weiteren Gehäusebereich 17 des Modulgehäuses 14, welcher aus Kunststoff ist und an dem zweiten Schaltungsträger 5 anliegt. Es wird somit eine thermische Kopplung von den Halbleiterschaltern 6 unter Umgehung des Übergangsbereichs 19 über den gut wärmeleitfähigen ersten Schaltungsträger 4 und den metallischen Gehäusebereich 15 sowie weiterhin über die Folie 13, den weiteren Gehäusebereich 17 und den zweiten Schaltungsträger 5 hin zu dem Temperatursensor 8 hergestellt. Die Folie 13 erstreckt sich dabei derart vollflächig über die erste Seite 16 des Leistungselektronikmoduls 2, dass sie in gegenseitiger Überlappung bzw. in Überdeckung mindestens sowohl mit den Halbleiterschaltern 6 als auch mit dem Temperatursensor 8 angeordnet ist.

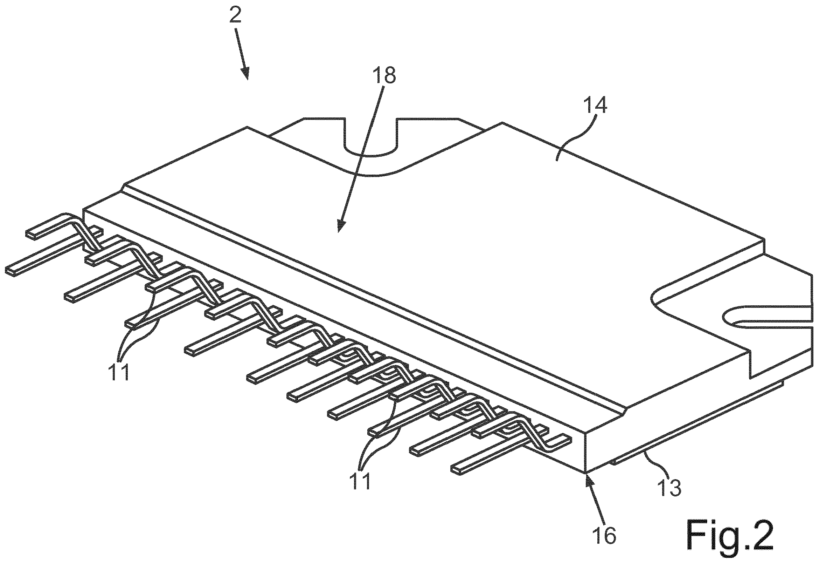

Das Leistungselektronikmodul 2 ist in perspektivischer Darstellung in Fig. 2 gezeigt. Hier ist eine der ersten Seite 16 gegenüberliegende zweite Seite 18 des Leistungselektronikmoduls 2 bzw. des Modulgehäuses 14 gezeigt. Wie aus Fig. 2 hervorgeht, ragen aus dem Modulgehäuse 14 die elektrischen Kontaktelemente 11 heraus, über welche das Leistungselektronikmodul 2 an die Platine 10 angeschlossen wird.

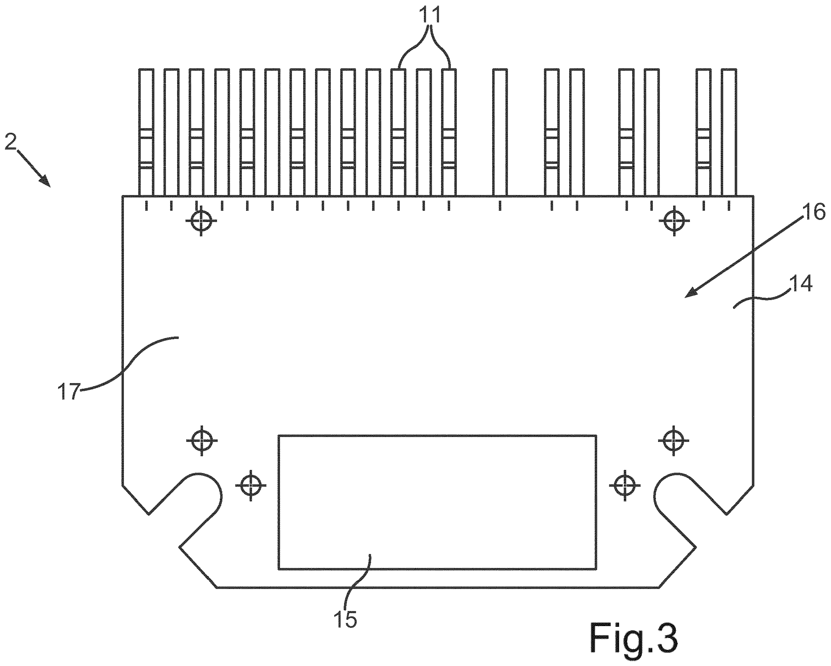

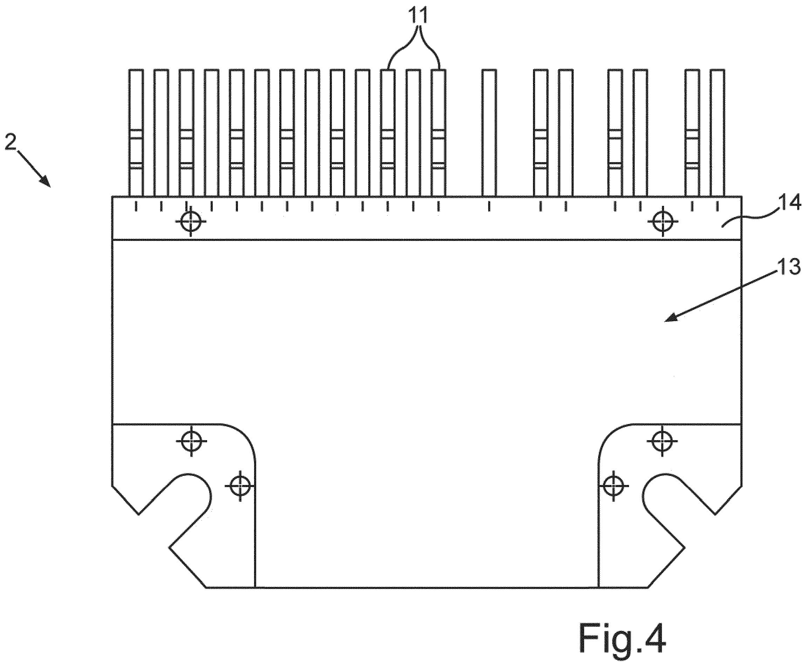

In Fig. 3 ist eine Draufsicht auf die erste Seite 16 des Leistungselektronikmoduls 2 ohne die Folie 13 gezeigt. Hier ist insbesondere der metallische Gehäusebereich 15 gut erkennbar, welcher den ersten Schaltungsträger (siehe Fig. 1) überlappt. Fig. 4 zeigt hingegen eine Draufsicht auf die erste Seite 16 des Leistungselektronikmoduls 2 einschließlich der Folie 13. Wie aus Fig. 4 hervorgeht, verdeckt die Folie 13 sowohl den metallischen Gehäusebereich 15 als auch den weiteren Gehäusebereich 17 und somit im Wesentlichen die gesamte Fläche bzw. die gesamte Seite 16 des Leistungselektronikmoduls 2.

Gemäß Fig. 5 ist die Folie 13 in Sandwich-Bauweise zwischen dem Leistungselektronikmodul 2 einerseits und dem Kühlkörper 12 andererseits angeordnet. Die Folie 13 hat hier zwei verschiedene Funktionen: einerseits die Funktion der Wärmeübertragung zwischen den Halbleiterschaltern 6 und dem Temperatursensor 8 sowie andererseits die Funktion der Wärmeleitung vom Leistungselektronikmodul 2 zum Kühlkörper 12.

### Bezugszeichenliste

- 1: Vorrichtung
- 2: Leistungselektronikmodul
- 3: Hybridleiterplatte
- 4: Schaltungsträger
- 5: Schaltungsträger
- 6: Halbleiterschalter
- 7: Treiberschaltung
- 8: Temperatursensor
- 9: Bauelemente
- 10: Platine
- 11: Kontaktelemente
- 12: Kühlkörper
- 13: Folie
- 14: Modulgehäuse
- 15: Gehäusebereich
- 16: erste Seite
- 17: Gehäusebereich
- 18: zweite Seite
- 19: Übergangsbereich

## Patentansprüche

1. Vorrichtung (1) zum Versorgen eines elektrischen Verbrauchers eines Haushaltsgeräts mit elektrischer Versorgungsspannung, umfassend ein Leistungselektronikmodul (2), welches eine Hybridleiterplatte (3) mit einem ersten Schaltungsträger (4) und einem zweiten Schaltungsträger (5) aufweist, wobei ein Übergangsbereich (19) zwischen dem ersten und dem zweiten Schaltungsträger (4, 5) eine gegenüber dem ersten und/oder dem zweiten Schaltungsträger (4, 5) geringere Wärmeleitfähigkeit aufweist, und umfassend eine Temperaturschutzeinrichtung zum Temperaturschutz des Leistungselektronikmoduls (2), wobei auf dem ersten Schaltungsträger (4) der Hybridleiterplatte (3) zumindest ein Halbleiterschalter (6) angeordnet ist, der zum Erzeugen der Versorgungsspannung für den elektrischen Verbraucher ausgebildet ist, und auf dem zweiten Schaltungsträger (5) der Hybridleiterplatte (3) ein Temperatursensor (8) der Temperaturschutzeinrichtung zum Erfassen einer Temperatur angeordnet ist, welcher der zumindest eine Halbleiterschalter (6) im Betrieb der Vorrichtung (1) ausgesetzt ist, **dadurch gekennzeichnet, dass** an einem Modulgehäuse des Leistungselektronikmoduls (2) eine thermisch leitfähige Folie (13) angeordnet ist, welche an einem metallischen Gehäusebereich des Modulgehäuses, welcher den ersten Schaltungsträger kontaktiert, sowie an einem weiteren Gehäusebereich, welcher aus Kunststoff ist und den zweiten Schaltungsträger kontaktiert, anliegt und dass über die Folie (13) der zumindest eine Halbleiterschalter (6) und der Temperatursensor (8) thermisch miteinander gekoppelt sind.

2. Vorrichtung (1) nach Anspruch 1, **dadurch gekennzeichnet, dass** der erste Schaltungsträger (4) wenigstens eine Keramik-Schicht aufweist.

3. Vorrichtung (1) nach Anspruch 1 oder 2, **dadurch gekennzeichnet, dass** der zweite Schaltungsträger (5) organischen Kunststoff aufweist.

4. Vorrichtung (1) nach einem der vorhergehenden Ansprüche, **dadurch gekennzeichnet, dass** die Vorrichtung (1) einen Kühlkörper (12) zur Wärmeabfuhr von dem Leistungselektronikmodul (2) aufweist, wobei das Leistungselektronikmodul (2) über die Folie (13) an den Kühlkörper (12) thermisch angebunden ist.

5. Vorrichtung (1) nach einem der vorhergehenden Ansprüche, **dadurch gekennzeichnet, dass** die Folie (13) aus einem Material gebildet ist, welches Graphit und/oder Kupfer umfasst.

6. Vorrichtung (1) nach einem der vorhergehenden Ansprüche, **dadurch gekennzeichnet, dass** die Folie (13) auf das Leistungselektronikmodul (2), insbesondere auf ein Modulgehäuse (14) des Leistungselektronikmoduls (2), geklebt ist.

7. Haushaltsgerät mit einem elektrischen Verbraucher, insbesondere einer elektrischen Maschine, und mit einer Vorrichtung (1) zum Versorgen des elektrischen Verbrauchers nach einem der vorhergehenden Ansprüche.

8. Verfahren zum Herstellen einer Vorrichtung (1) zum Versorgen eines elektrischen Verbrauchers eines Haushaltsgeräts mit elektrischer Versorgungsspannung, durch Bereitstellen eines Leistungselektronikmoduls (2), welches eine Hybridleiterplatte (3) mit einem ersten Schaltungsträger (4) und einem zweiten Schaltungsträger (5) aufweist, wobei ein Übergangsbereich (19) zwischen dem ersten und dem zweiten Schaltungsträger (4, 5) eine gegenüber dem ersten und/oder dem zweiten Schaltungsträger (4, 5) geringere Wärmeleitfähigkeit aufweist, und durch Bereitstellen einer Temperaturschutzeinrichtung zum Temperaturschutz des Leistungselektronikmoduls (2), wobei auf dem ersten Schaltungsträger (4) der Hybridleiterplatte (3) zumindest ein Halbleiterschalter (6) angeordnet wird, der zum Erzeugen der Versorgungsspannung für den elektrischen Verbraucher ausgebildet ist, und auf dem zweiten Schaltungsträger (5) der Hybridleiterplatte (3) ein Temperatursensor (8) der Temperaturschutzeinrichtung zum Erfassen einer Temperatur angeordnet wird, welcher der zumindest eine Halbleiterschalter (6) im Betrieb der Vorrichtung (1) ausgesetzt wird, **dadurch gekennzeichnet, dass** an einem Modulgehäuse des Leistungselektronikmoduls (2) eine thermisch leitfähige Folie (13) angeordnet wird, welche an einem metallischen Gehäusebereich des Modulgehäuses, welcher den ersten Schaltungsträger kontaktiert, sowie an einem weiteren Gehäusebereich, welcher aus Kunststoff ist und den zweiten Schaltungsträger kontaktiert, anliegt und dass über die Folie der zumindest eine Halbleiterschalter (6) und der Temperatursensor (8) thermisch miteinander gekoppelt werden.

## Claims

1. Device (1) for supplying an electrical load of a household appliance with electrical supply voltage, comprising a power electronics module (2), which has a hybrid printed circuit board (3) having a first circuit carrier (4) and a second circuit carrier (5), wherein a transition region (19) between the first and the second circuit carrier (4, 5) has a lower heat conductivity with respect to the first and/or the second circuit carrier (4, 5), and comprising a temperature protection device for the temperature protection of the power electronics module (2), wherein on the first circuit carrier (4) of the hybrid printed circuit board (3) at least one semiconductor switch (6) is arranged, which is configured for generating the supply voltage for the electrical load, and on the second circuit carrier (5) of the hybrid printed circuit board (3) a temperature sensor (8) of the temperature protection device for detecting a temperature is arranged, to which temperature the at least one semiconductor switch (6) is subjected during the operation of the device (1), **characterised in that** on a module housing of the power electronics module (2) a thermally conductive foil (13) is arranged, which abuts a metallic housing area of the module housing which is in contact with the first circuit carrier, and an additional housing area which is made of plastic and is in contact with the second circuit carrier and **in that** by way of the foil (13) the at least one semiconductor switch (6) and the temperature sensor (8) are thermally coupled to one another.

2. Device (1) according to claim 1, **characterised in that** the first circuit carrier (4) has at least one ceramic layer.

3. Device (1) according to claim 1 or 2, **characterised in that** the second circuit carrier (5) contains organic plastic.

4. Device (1) according to one of the preceding claims, **characterised in that** the device (1) has a heat sink (12) for heat dissipation from the power electronics module (2), wherein the power electronics module (2) is thermally coupled to the heat sink (12) by way of the foil (13).

5. Device (1) according to one of the preceding claims, **characterised in that** the foil (13) is made of a material comprising graphite and/or copper.

6. Device (1) according to one of the preceding claims, **characterised in that** the foil (13) is affixed to the power electronics module (2), in particular to a module housing (14) of the power electronics module (2).

7. Household appliance with an electrical load, in particular an electrical machine, and with a device (1) for supplying the electrical load as claimed in one of the preceding claims.

8. Method for producing a device (1) for supplying an electrical load of a household appliance with electrical supply voltage through the provision of a power electronics module (2) which has a hybrid printed circuit board (3) with a first circuit carrier (4) and a second circuit carrier (5), wherein a transition region (19) between the first and the second circuit carrier (4, 5) has a lower heat conductivity with respect to the first and/or the second circuit carrier (4, 5), and through the provision of a temperature protection device for protecting the temperature of the power electronics module (2), wherein at least one semiconductor switch (6) is arranged on the first circuit carrier (4) of the hybrid printed circuit board (3), and is configured for generating the supply voltage for the electrical load, and a temperature sensor (8) of the temperature protection device for detecting the temperature is arranged on the second circuit carrier (5) of the hybrid printed circuit board (3), to which temperature the at least one semiconductor switch (6) is subjected during the operation of the device (1), **characterised in that** on a module housing of the power electronics module (2) a thermally conductive foil (13) is arranged, which abuts a metallic housing area of the module housing which is in contact with the first circuit carrier, and an additional housing area which is made of plastic and is in contact with the second circuit carrier and **in that** by way of the foil the at least one semiconductor switch (6) and the temperature sensor (8) are thermally coupled to one another.

## Revendications

1. Dispositif (1) destiné à fournir une tension d'alimentation électrique à un consommateur électrique d'un appareil électroménager, comprenant un module électronique de puissance (2) doté d'un circuit imprimé hybride (3) avec un premier support de circuit (4) et un deuxième support de circuit (5), une zone de transition (19) située entre le premier et le deuxième support de circuit (4, 5) présentant une conductibilité thermique inférieure à celle du premier et/ou du deuxième support de circuit (4, 5), et comprenant un moyen de protection thermique servant à assurer la protection thermique du module électronique de puissance (2), sur ledit premier support de circuit (4) du circuit imprimé hybride (3) étant disposé au moins un commutateur à semi-conducteur (6), adapté pour générer la tension d'alimentation du consommateur électrique, et sur le deuxième support de circuit (5) du circuit imprimé hybride (3) étant disposé un capteur de température (8) du système de protection thermique, servant à détecter une température à laquelle est exposé le au moins un commutateur à semi-conducteur (6) lorsque le dispositif (1) est en fonctionnement, **caractérisé en ce qu'**une feuille thermoconductrice (13) est placée sur un boîtier de module du module électronique de puissance (2), laquelle feuille est appliquée contre une zone de boîtier métallique du boîtier de module, qui met en contact le premier support de circuit, ainsi que contre une autre zone du boîtier, qui est en matière plastique et met en contact le deuxième support de circuit, et que le au moins un commutateur à semi-conducteur (6) et le capteur de température (8) sont thermiquement couplés entre eux par l'intermédiaire de la feuille (13).

2. Dispositif (1) selon la revendication 1, **caractérisé en ce que** le premier support de circuit (4) comporte au moins une couche de céramique.

3. Dispositif (1) selon la revendication 1 ou 2, **caractérisé en ce que** le deuxième support de circuit (5) comporte une matière plastique organique.

4. Dispositif (1) selon l'une des revendications précédentes, **caractérisé en ce que** le dispositif (1) comporte un corps de refroidissement (12) pour évacuer la chaleur du module électronique de puissance (2), le module électronique de puissance (2) étant relié thermiquement au corps de refroidissement (12) par l'intermédiaire de la feuille (13).

5. Dispositif (1) selon l'une des revendications précédentes, **caractérisé en ce que** la feuille (13) est formée à partir d'un matériau qui comprend du graphite et/ou du cuivre.

6. Dispositif (1) selon l'une des revendications précédentes, **caractérisé en ce que** la feuille (13) est collée sur le module électronique de puissance (2), en particulier sur un boîtier de module (14) du module électronique de puissance (2).

7. Appareil électroménager comprenant un consommateur électrique, en particulier une machine électrique, et comprenant un dispositif (1) pour l'alimentation du consommateur électrique selon l'une des revendications précédentes.

8. Procédé de fabrication d'un dispositif (1) destiné à fournir une tension d'alimentation électrique à un consommateur électrique d'un appareil électroménager, en fournissant un module électronique de puissance (2) doté d'un circuit imprimé hybride (3) avec un premier support de circuit (4) et un deuxième support de circuit (5), une zone de transition (19) située entre le premier et le deuxième support de circuit (4, 5) présentant une conductibilité thermique inférieure à celle du premier et/ou du deuxième support de circuit (4, 5), et en fournissant un moyen de protection thermique servant à assurer la protection thermique du module électronique de puissance (2), sur ledit premier support de circuit (4) du circuit imprimé hybride (3) étant disposé au moins un commutateur à semi-conducteur (6), adapté pour générer la tension d'alimentation du consommateur électrique, et sur ledit deuxième support de circuit (5) du circuit imprimé hybride (3) étant disposé un capteur de température (8) du système de protection thermique, servant à détecter une température à laquelle est exposé le au moins un commutateur à semi-conducteur (6) lorsque le dispositif (1) est en fonctionnement, **caractérisé en ce qu'**une feuille thermoconductrice (13) est placée sur un boîtier de module du module électronique de puissance (2), laquelle feuille est appliquée contre une zone de boîtier métallique du boîtier de module, qui met en contact le premier support de circuit, ainsi que contre une autre zone du boîtier, qui est en matière plastique et met en contact le deuxième support de circuit, et que le au moins un commutateur à semi-conducteur (6) et le capteur de température (8) sont thermiquement couplés entre eux par l'intermédiaire de la feuille (13).
